(19) Europäisches Patentamt
European Patent Office
Office européen des brevets

(11) **EP 3 655 785 B1**

(12) **EUROPÄISCHE PATENTSCHRIFT**

(45) Veröffentlichungstag und Bekanntmachung des Hinweises auf die Patenterteilung:
**31.05.2023  Patentblatt 2023/22**

(21) Anmeldenummer: **18737616.5**

(22) Anmeldetag: **06.07.2018**

(51) Internationale Patentklassifikation (IPC):
*G01R 19/04* ^(2006.01)    *G01R 19/25* ^(2006.01)

(52) Gemeinsame Patentklassifikation (CPC):
**G01R 19/04; G01R 19/2513**

(86) Internationale Anmeldenummer:
**PCT/EP2018/068381**

(87) Internationale Veröffentlichungsnummer:
**WO 2019/015998 (24.01.2019 Gazette 2019/04)**

(54) **SCHALTUNGSANORDNUNG UND VERFAHREN ZUR ÜBERWACHUNG WECHSELSPANNUNGSFÖRMIGER SIGNALE**

SWITCHING ARRANGEMENT AND METHOD FOR MONITORING AC SIGNALS

SYSTÈME DE CIRCUIT ET PROCÉDÉ DE SURVEILLANCE DE SIGNAUX SOUS FORME DE TENSION ALTERNATIVE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **21.07.2017   DE 102017116534**

(43) Veröffentlichungstag der Anmeldung:
**27.05.2020   Patentblatt 2020/22**

(73) Patentinhaber: **Eaton Intelligent Power Limited 4 Dublin (IE)**

(72) Erfinder: **CULCA, Horea 53797 Lohmar (DE)**

(74) Vertreter: **Epping - Hermann - Fischer Patentanwaltsgesellschaft mbH Schloßschmidstraße 5 80639 München (DE)**

(56) Entgegenhaltungen:
**GB-A- 1 254 975     US-A- 5 299 149**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

**Beschreibung**

Die vorliegende Erfindung betrifft eine Schaltungsanordnung sowie ein Verfahren zur Überwachung wechselspannungsförmiger (AC) Signale, insbesondere AC-Eingangssignale elektronischer Steuergeräte, wie speicherprogrammierbare Steuerungen (SPS) oder Logikrelais, oder AC-Eingangssignale bzw. -spannungen von ähnlichen Geräten sowie ein entsprechendes Software-Produkt.

Kleine programmierbare Steuerungen, wie z.B. SPS bzw. programmierbare Logikrelais bieten in der Regel Varianten, die mit Wechselspannung versorgt werden (meist Weitbereich 85 bis 264 VAC) und entsprechende AC-Eingänge aufweisen. Für die Erkennung von AC-Eingangssignalen für derartige Steuerungen ist eine Unterscheidung bzw. Erkennung eines bestimmten Grenz- bzw. Schwellenwertes unabdingbar. Eine genaue und schnelle Erfassung dieses definierten Schwellenwertes ist für verschiedene Anwendungen besonders vorteilhaft.

Eine herkömmliche Methode, um die AC-Eingangssignale einem verarbeitenden Mikrocontroller als Logiksignale zur Verfügung zu stellen, ist das Wechselspannungssignal gleichzurichten und zu glätten (zu filtern), um ein Quasi-DC-Signal zu erzeugen. Aus diesem Quasi-DC-Signal wird dann durch entsprechendes Herunterteilen und Vergleichen ein logisches Signal erzeugt. Das Quasi-DC-Signal weist jedoch noch eine bestimmte Welligkeit (Restwelligkeit) auf. Diese genannte Welligkeit ist ein Kompromiss zwischen Güte des DC-Signals (je glatter desto besser und unproblematischer der Vergleich) und Schnelligkeit. Denn je besser gefiltert wird, z.B. mit einer umso größeren Kapazität, desto langsamer entlädt sich diese Kapazität, wenn am Eingang das Signal abgeschaltet wird. Aufwendigere Schaltungen können das Ergebnis optimieren.

Aus EP 0935758 B1 sind eine Schaltungsanordnung und ein Verfahren bekannt, die die Nachteile dieser herkömmlichen Lösung beseitigen, indem AC-Eingangssignale nicht gefiltert werden, sondern lediglich in entsprechende Impulse umgewandelt werden. Dabei wird aus der Versorgungsspannung des Gerätes ein Nulldurchgangssignal erzeugt und nach einer Verzögerung von einem Viertel der Periodendauer (90° bzw. $\pi/2$ Phasenwinkel), also im Scheitelpunkt der Versorgungsspannung, ein digitalisierter Eingang gelesen. Die dargestellte Methode setzt voraus, dass die Eingangssignale aus der gleichen Phase (L1 oder L2 oder L3) abgeleitet werden, wie die Versorgungsspannung des Gerätes. Somit ist mittels dieser Methode nur die Überwachung einer Phase möglich. Weiterer Stand der Technik findet sich in GB 1254975.

Aus der Praxis kommt jedoch die Anforderung, AC-Eingangssignale zu überwachen, die nicht nur aus einer, insbesondere der gleichen, Phase stammen, wie die Versorgungsspannung, sondern aus mehreren, vorzugsweise allen drei Phasen eines Versorgungsnetzes.

Es ist daher eine Aufgabe der Erfindung, eine Schaltungsanordnung und ein Verfahren der eingangs genannten Art aufzuzeigen, die eine Überwachung von AC-Eingangssignalen aus mehreren Phasen ermöglichen und dennoch eine hohe Verarbeitungsgeschwindigkeit aufweisen sowie einfach zu implementieren sind.

Die Aufgabe wird in einem ersten Aspekt durch eine Schaltungsanordnung zur Überwachung wechselspannungsförmiger Signale gemäß Patentanspruch 1 gelöst. Die Schaltungsanordnung weist einen oder mehrere Komparatoren auf, denen jeweils an einem ersten Vergleichseingang ein zu überwachendes, wechselspannungsförmiges Signal oder ein daraus gewonnenes Signal zuführbar ist zum Vergleich mit einem an einem zweiten Vergleichseingang anliegenden, definierten Amplitudenschwellenwert, sodass an einem Ausgang ein erstes Ausgangssignal erzeugbar ist. Das zu überwachende, wechselspannungsförmige Signal kann entweder direkt in den bzw. die Komparatoren gespeist werden oder zuvor vorverarbeitet werden, sodass ein daraus gewonnenes Signal dem oder den

Komparatoren zuführbar ist. Eine entsprechende Vorverarbeitung kann ein Gleichrichten durch einen Gleichrichter (z.B. zur Halbwellengleichrichtung) bzw. Tiefsetzen durch einen Tiefsetzer umfassen. Das zu überwachende, wechselspannungsförmige Signal kann z.B. ein Spannungssignal einer Phase eines dreiphasigen Versorgungsnetzes sein.

Die Schaltungsanordnung weist ferner einen Nulldurchgangsdetektor auf, dem an einem Überwachungseingang ein Referenzsignal oder ein daraus gewonnenes Signal zuführbar ist, sodass an einem Ausgang des Nulldurchgangsdetektors ein zweites Ausgangssignal erzeugbar ist. Das Referenzsignal kann z.B. eine Versorgungsspannung eines elektronischen Gerätes (z.B. SPS, Logikrelais oder ähnliches Gerät) sein, in dem die hier erläuterte Schaltungsanordnung Anwendung findet. Das Referenzsignal kann entweder direkt in den Nulldurchgangsdetektor gespeist werden oder zuvor vorverarbeitet werden, sodass ein daraus gewonnenes Signal dem Nulldurchgangsdetektor zuführbar ist. Eine entsprechende Vorverarbeitung kann analog zu den oben genannten Maßnahmen ein Gleichrichten durch einen Gleichrichter (vorteilhaft Halbwellengleichrichtung) umfassen. Optional kann die Vorverarbeitung zusätzlich auch ein Strombegrenzen durch einen Widerstand oder ein Tiefsetzen durch einen Tiefsetzer umfassen.

Die Schaltungsanordnung weist ferner ein dem Nulldurchgangsdetektor nachgeschaltetes erstes Zeitglied zur Erzeugung eines ersten Taktsignals in Abhängigkeit vom zweiten Ausgangssignal, und ein dem Nulldurchgangsdetektor nachgeschaltetes zweites Zeitglied zur Erzeugung eines zweiten Taktsignals in Abhängigkeit vom zweiten Ausgangssignal oder in Abhängigkeit vom ersten Taktsignal auf. Das zweite Taktsignal unterscheidet sich vom ersten Taktsignal.

Die Schaltungsanordnung weist ferner ein erstes flankengesteuertes Flip-Flop und ein zweites flankengesteuertes Flip-Flop auf. Der Ausgang des Komparators oder die Ausgänge der Komparatoren sind jeweils mit einem zustandsgesteuerten Eingang des ersten Flip-Flops bzw. des zweiten Flip-Flops verbunden. Ein Ausgang des ersten Zeitglieds ist mit einem flankengesteuerten Eingang des ersten Flip-Flops verbunden.

Ein Ausgang des zweiten Zeitglieds ist mit einem flankengesteuerten Eingang des zweiten Flip-Flops verbunden. Auf diese Weise sind ein erstes Zustandssignal an einem Ausgang des ersten Flip-Flops erzeugbar und ein zweites Zustandssignal an einem Ausgang des zweiten Flip-Flops erzeugbar.

Das wechselspannungsförmige Signal wird somit relativ zu dem definierten Amplitudenschwellenwert überwacht. Der definierte Amplitudenschwellenwert kann vorbestimmt und konstant sein.

Die Schaltungsanordnung der erläuterten Art ermöglicht somit auf einfache Weise eine Überwachung von verschiedenen AC-Eingangssignalen, die zueinander phasenverschoben sind, d.h. aus verschiedenen Phasen eines Versorgungsnetzes stammen können. Die Schaltungsanordnung ist ausgelegt, verschiedene AC-Eingangssignale relativ zum Amplitudenschwellenwert zu überwachen. Z.B. kann ein erstes AC-Eingangssignal überwacht werden, das frequenz- und phasengleich zum Referenzsignal ist, und ein zweites AC-Eingangssignal überwacht werden, das bezüglich des ersten AC-Eingangssignals bzw. des Referenzsignals phasenverschoben ist.

Das wechselspannungsförmige Signal kann somit als AC-Eingangssignal realisiert sein.

Durch Einrichten zweier Zeitglieder, die unterschiedliche Taktsignale erzeugen, und zweier Flip-Flops, die durch die unterschiedlichen Taktsignale gesteuert werden, können Amplitudenwerte zumindest zweier zeitlich versetzter AC-Eingangssignale relativ zu dem definierten Amplitudenschwellenwert überwacht werden. Dennoch ist die Schaltungsanordnung einfach zu implementieren und erlaubt eine hohe Verarbeitungsgeschwindigkeit.

In diversen Ausführungsformen der Schaltungsanordnung ist das erste Zeitglied eingerichtet, durch das zweite Ausgangssignal zur Erzeugung des ersten Taktsignals getriggert zu werden. Somit löst das zweite Ausgangssignal das erste Taktsignal aus.

In diversen Ausführungsformen der Schaltungsanordnung ist das zweite Zeitglied dem ersten Zeitglied nachgeschaltet und eingerichtet durch das erste Taktsignal zur Erzeugung des zweiten Taktsignals getriggert zu werden. Somit löst das erste Taktsignal das zweite Taktsignal aus.

Eine Kombination dieser Ausgestaltungen sieht also vor, dass das zweite Ausgangssignal das erste Taktsignal auslöst, und das erste Taktsignal wiederum das zweite Taktsignal auslöst. Auf diese Weise werden das erste und das zweite Taktsignal in Abhängigkeit vom zweiten Ausgangssignal ausgelöst, das seinerseits aus dem Referenzsignal gewonnen wird. Somit dient das Referenzsignal als Referenz für die Erzeugung des ersten und zweiten Taktsignals.

In diversen Ausführungsformen weist die Schaltungsanordnung zudem ein dem Nulldurchgangsdetektor nachgeschaltetes drittes Zeitglied auf zur Erzeugung eines dritten Taktsignals in Abhängigkeit vom zweiten Ausgangssignal oder in Abhängigkeit vom ersten Taktsignal oder in Abhängigkeit vom zweiten Taktsignal. Das dritte Taktsignal unterscheidet sich vom ersten Taktsignal und vom zweiten Taktsignal. In diesen Ausführungsformen weist die Schaltungsanordnung zudem ein drittes flankengesteuertes Flip-Flop auf. Der Ausgang des Komparators oder die Ausgänge der Komparatoren sind mit einem zustandsgesteuerten Eingang des dritten Flip-Flops verbunden. Ein Ausgang des dritten Zeitglieds ist mit einem flankengesteuerten Eingang des dritten Flip-Flops derart verbunden, dass ein drittes Zustandssignal an einem Ausgang des dritten Flip-Flops erzeugbar ist. In diesen Ausführungsformen können durch Einrichten dreier Zeitglieder, die jeweils unterschiedliche Taktsignale erzeugen, und dreier Flip-Flops, die durch die unterschiedlichen Taktsignale gesteuert werden, Amplitudenwerte von drei zeitlich versetzten AC-Eingangssignalen relativ zu dem definierten Amplitudenschwellenwert überwacht werden. Somit erlaubt die Schaltungsanordnung in dieser Konstellation die Überwachung von AC-Eingangssignalen sämtlicher Phasen eines dreiphasigen Versorgungsnetzes.

Das dritte Zeitglied ist vorteilhaft dem zweiten Zeitglied nachgeschaltet und eingerichtet, durch das zweite Taktsignal zur Erzeugung des dritten Taktsignals getriggert zu werden. Somit löst das zweite Taktsignal das dritte Taktsignal aus. Eine Kombination dieser Ausgestaltung mit den obigen Ausgestaltungen sieht vor, dass das zweite Ausgangssignal das erste Taktsignal auslöst, das erste Taktsignal wiederum das zweite Taktsignal auslöst und das zweite Taktsignal wiederum das dritte Taktsignal auslöst. Auf diese Weise werden das erste, das zweite und das dritte Taktsignal in Abhängigkeit vom zweiten Ausgangssignal ausgelöst, das seinerseits aus dem Referenzsignal gewonnen wird. Somit dient das Referenzsignal als Referenz für die Erzeugung des ersten, zweiten und dritten Taktsignals.

In diversen Ausführungsformen der Schaltungsanordnung sind die Flip-Flops und/oder die Zeitglieder durch Software innerhalb eines Mikrocontrollers realisiert. Auf diese Weise ist eine sehr einfache Implementierung der Schaltungsanordnung bzw. von Teilen der Schaltungsanordnung in Software möglich.

In diversen Ausführungsformen weist die Schaltungsanordnung weiter ein ODER-Gatter zur Erzeugung eines Gesamtzustandssignals, zumindest aus dem ersten Zustandssignal und dem zweiten Zustandssignal auf. Das Gesamtzustandssignal kann als (digitales) Eingangssignal für eine weitere Steuerung eines elektronischen Gerätes herangezogen werden, in dem die Schaltungsanordnung eingesetzt wird. In Ausführungsformen mit einem dritten Zeitglied und einem dritten Flip-Flop zur Erzeugung eines dritten Zustandssignals der oben erläuterten Art kann das ODER-Gatter zur Erzeugung eines Gesamtzustandssignals aus dem ersten, zweiten und dritten Zustandssignal eingerichtet sein.

Die obige Aufgabe wird in einem zweiten Aspekt durch ein Verfahren zur Überwachung wechselspannungsförmiger Signale gemäß Patentanspruch 5 gelöst.

Das Verfahren umfasst die folgenden Verfahrensschritte:

a) Erfassen eines zu überwachenden, wechselspannungsförmigen Signals,

b) Prüfen, ob ein Amplitudenwert des erfassten wechselspannungsförmigen Signals oder eines daraus gewonnenen Signals über oder unter einem definierten Amplitudenschwellenwert liegt, und in Abhängigkeit davon Erzeugen eines ersten Ausgangssignals,

c) Überwachen der Nulldurchgänge eines wechselspannungsförmigen Referenzsignals oder eines daraus gewonnenen Signals und in Abhängigkeit davon Erzeugen eines zweiten Ausgangssignals,

d1) Erzeugen eines ersten Taktsignals in Abhängigkeit vom zweiten Ausgangssignal und

d2) Erzeugen eines zweiten Taktsignals in Abhängigkeit vom zweiten Ausgangssignal oder in Abhängigkeit vom ersten Taktsignal, wobei sich das erste Taktsignal vom zweiten Taktsignal zumindest durch den Zeitpunkt eines definierten Zustandswechsels unterscheidet, und

f) Erzeugen eines ersten Zustandssignals bzw. eines zweiten Zustandssignals durch Auswerten des ersten Ausgangssignals im Zeitpunkt des Zustandswechsels des ersten Taktsignals bzw. im Zeitpunkt des Zustandswechsels des zweiten Taktsignals.

Ein derartiges Verfahren ermöglicht somit auf einfache Weise eine Überwachung der Amplitudenwerte von verschiedenen AC-Eingangssignalen, die zueinander phasenverschoben sind, d.h. aus verschiedenen Phasen eines Versorgungsnetzes stammen können, hinsichtlich des definierten Amplitudenschwellenwertes. Z.B. kann ein erstes AC-Eingangssignal überwacht werden, das frequenz- und phasengleich zum Referenzsignal ist, und ein zweites AC-Eingangssignal überwacht werden, das bezüglich des ersten AC-Eingangssignals bzw. des Referenzsignals phasenverschoben ist. Durch Auswerten des ersten Ausgangssignals zu unterschiedlichen Zeitpunkten definierter Zustandswechsel des ersten und zweiten Taktsignals kann für verschiedene, zueinander phasenverschobene AC-Eingangssignale entschieden werden, ob der Amplitudenwert über oder unter dem definierten Amplitudenschwellenwert liegt. Eine etwaige Vorverarbeitung des erfassten wechselspannungsförmigen Signals oder des wechselspannungsförmigen Referenzsignals kann unter Anwendung der im Zusammenhang mit der oben erläuterten Schaltungsanordnung dargestellten Maßnahmen und Mittel erfolgen.

In einer Weiterbildung umfasst das Verfahren:

- Erzeugen eines dritten Taktsignals in Abhängigkeit vom zweiten Ausgangssignal oder in Abhängigkeit vom zweiten Taktsignal. Dabei unterscheidet sich das dritte Taktsignal vom ersten und vom zweiten Taktsignal zumindest durch den Zeitpunkt eines definierten Zustandswechsels.

- Erzeugen eines dritten Zustandssignals durch Auswerten des ersten Ausgangssignals im Zeitpunkt des Zustandswechsels des dritten Taktsignals.

In diversen Implementierungen des Verfahrens wird das erste Taktsignal durch ein erstes Zeitglied erzeugt, das durch das zweite Ausgangssignal zur Erzeugung des ersten Taktsignals getriggert wird, und das zweite Taktsignal durch ein zweites Zeitglied erzeugt, das durch das erste Taktsignal zur Erzeugung des zweiten Taktsignals getriggert wird. Auf diese Weise werden das erste und das zweite Taktsignal in Abhängigkeit vom zweiten Ausgangssignal ausgelöst, das seinerseits aus dem Referenzsignal gewonnen wird. Somit dient das Referenzsignal als Referenz für die Erzeugung des ersten und zweiten Taktsignals.

In diversen Implementierungen des Verfahrens sind das erste Zeitglied und das zweite Zeitglied softwaregesteuert bzw. softwareimplementiert innerhalb eines Mikrocontrollers realisiert. In diesen Implementierungen können die folgenden Verfahrensschritte durchgeführt werden:

- Erzeugen eines ersten Interrupts im Mikrocontroller durch das zweite Ausgangssignal,
- Starten eines ersten Timers des Mikrocontrollers bei Auftreten des ersten Interrupts zur Realisierung des ersten Zeitglieds,
- Erzeugen eines zweiten Interrupts im Mikrocontroller bei Ablauf des ersten Timers,
- Starten des ersten Timers oder eines zweiten Timers des Mikrocontrollers bei Auftreten des zweiten Interrupts zur Realisierung des zweiten Zeitglieds,
- Lesen und Speichern des bei Auftreten des zweiten Interrupts vorliegenden Wertes des ersten Ausgangssignals als erstes Zustandssignal,
- Erzeugen eines dritten Interrupts im Mikrocontroller bei Ablauf des ersten bzw. des zweiten Timers,
- Lesen und Speichern des bei Auftreten des dritten Interrupts vorliegenden Wertes des ersten Ausgangssignals als zweites Zustandssignal. Derartige Maßnahmen ermöglichen eine besonders einfache und schnelle Verarbeitung der erfassten AC-Eingangssignale in die entsprechenden Zustandssignale für eine weitere (logische) Verarbeitung innerhalb eines elektronischen Gerätes, in dem das Verfahren implementiert wird.

In einer Weiterbildung umfasst das Verfahren: Starten des ersten oder des zweiten Timers oder eines dritten Timers des Mikrocontrollers bei Auftreten des dritten Interrupts, und Erzeugen eines vierten Interrupts im Mikrocontroller bei Ablauf des gestarteten Timers.

In einer Weiterbildung wird der bei Auftreten des vierten Interrupts vorliegende Wert des ersten Ausgangssignals gelesen und als drittes Zustandssignal gespeichert.

In einer Ausführungsform wird der erste Timer bei Auftreten des zweiten Interrupts zum zweiten Mal gestartet. Der dritte Interrupt wird im Mikrocontroller bei Ablauf des ersten Timers erzeugt. Beim ersten Starten und beim zweiten Starten des ersten Timers werden bevorzugt verschiedene Verzögerungen eingestellt. Vorteilhaft nutzt der Mikrocontroller somit den gleichen Timer, der jedes Mal mit dem entsprechenden Verzögerungswert programmiert wird. In einer Weiterbildung kann zur Realisierung des dritten Zeitglieds bei Auftreten des dritten Interrupts der erste Timer zum dritten Mal gestartet werden, wobei dann bei Ablauf des ersten Timers der vierte Interrupt erzeugt wird. Beim zweiten Starten und beim dritten Starten des ersten Timers wird bevorzugt die gleiche Verzögerung eingestellt. Somit werden die Interrupts verkettet erzeugt.

In einer alternativen Ausführungsform weist der Mikrocontroller den ersten und den zweiten Timer auf. Bei Auftreten des zweiten Interrupts wird der zweite Timer gestartet. Der dritte Interrupt wird im Mikrocontroller bei Ablauf des zweiten Timers erzeugt. Der erste und der zweite Timer weisen verschiedene Verzögerungen auf. In einer Weiterbildung kann zur Realisierung des dritten Zeitglieds bei Auftreten des dritten Interrupts der erste Timer zum zweiten Mal oder der zweite Timer zum zweiten Mal oder ein dritter Timer des Mikrocontrollers zum ersten Mal gestartet werden. Bei Ablauf des entsprechenden Timers wird der vierte Interrupt erzeugt.

In einer alternativen Ausführungsform weist der Mikrocontroller den ersten und den zweiten Timer auf. Die folgenden Verfahrensschritte werden durchgeführt:

- Erzeugen eines ersten Interrupts im Mikrocontroller durch das zweite Ausgangssignal,
- Starten des ersten und des zweiten Timers bei Auftreten des ersten Interrupts,
- Erzeugen eines zweiten Interrupts im Mikrocontroller bei Ablauf des ersten Timers,
- Lesen und Speichern des bei Auftreten des zweiten Interrupts vorliegenden Wertes des ersten Ausgangssignals als erstes Zustandssignal,
- Erzeugen eines dritten Interrupts im Mikrocontroller bei Ablauf des zweiten Timers,
- Lesen und Speichern des bei Auftreten des dritten Interrupts vorliegenden Wertes des ersten Ausgangssignals als zweites Zustandssignal.

Dabei ist die Verzögerung des zweiten Timers größer als die Verzögerung des ersten Timers. In einer Weiterbildung kann der Mikrocontroller einen dritten Timer umfassen, der bei Auftreten des ersten Interrupts gestartet wird, wobei bei Ablauf des dritten Timers der vierte Interrupt erzeugt wird. Die drei Timer sind somit separat realisiert. Die drei Timer starten zeitgleich, arbeiten parallel und enden hintereinander.

In diversen Implementierungen des Verfahrens korreliert der Zeitpunkt des Zustandswechsels des ersten Taktsignals mit dem Zeitpunkt eines Scheitelpunktes eines ersten, definierten wechselspannungsförmigen Signals, wobei der Zeitpunkt des Zustandswechsels des zweiten Taktsignals mit dem Zeitpunkt eines Scheitelpunktes eines zweiten, definierten wechselspannungsförmigen Signals korreliert, das zum ersten wechselspannungsförmigen Signal phasenverschoben ist. Auf diese Weise ist eine Erfassung von Amplitudenwerten verschiedener AC-Eingangssignale, die zueinander phasenverschoben sind, im jeweiligen Scheitelpunkt der AC-Eingangssignale möglich. Das bedeutet, dass eine sehr genaue Erfassung von Amplitudenwerten und eine Entscheidung gewährleistet sind, ob der entsprechende Amplitudenwert über oder unter dem definierten Amplitudenschwellenwert liegt.

Beispielsweise sind das wechselspannungsförmige Referenzsignal und das erste, definierte wechselspannungsförmige Signal frequenz- und phasengleich zueinander, wobei der Zeitpunkt des Zustandswechsels des ersten Taktsignals bei einem Viertel der Periodendauer nach einem Nulldurchgang des Referenzsignals liegt und der Zeitpunkt des Zustandswechsels des zweiten Taktsignals bei einem Drittel der Periodendauer nach dem Zeitpunkt des Zustandswechsels des ersten Taktsignals liegt. Auf diese Weise können AC-Eingangssignale zweier Phasen unterschieden werden, die um ein Drittel ihrer Periodendauer phasenverschoben sind.

In diversen Implementierungen des Verfahrens wird der weitere folgende Verfahrensschritt durchgeführt:

d3) Erzeugen eines dritten Taktsignals in Abhängigkeit vom zweiten Ausgangssignal oder in Abhängigkeit vom ersten Taktsignal oder in Abhängigkeit vom zweiten Taktsignal,
wobei sich das dritte Taktsignal vom ersten Taktsignal und vom zweiten Taktsignal zumindest durch den Zeitpunkt eines definierten Zustandswechsels unterscheidet, wobei in obigem Schritt f) ein drittes Zustandssignal durch Auswerten des ersten Signals im Zeitpunkt des Zustandswechsels des dritten Taktsignals erzeugt wird. In diesen Implementierungen des Verfahrens können Amplitudenwerte von drei zeitlich versetzten AC-Eingangssignalen relativ zum definierten Amplitudenschwellenwert überwacht werden. Somit erlaubt das Verfahren in dieser Konstellation die Überwachung von AC-Eingangssignalen sämtlicher Phasen eines dreiphasigen Versorgungsnetzes.

Das dritte Taktsignal wird vorteilhaft durch ein drittes Zeitglied erzeugt, das durch das zweite Taktsignal zur Erzeugung des dritten Taktsignals getriggert wird. Der Zeitpunkt des Zustandswechsels des dritten Taktsignals kann mit dem Zeitpunkt eines Scheitelpunktes eines dritten wechselspannungsförmigen Signals korrelieren, das zum ersten wechselspannungsförmigen Signal und zum zweiten wechselspannungsförmigen Signal phasenverschoben ist.

Beispielsweise liegt im Falle, dass das wechselspannungsförmige Referenzsignal und das erste wechselspannungsförmige Signal frequenz- und phasengleich sind, der Zeitpunkt des Zustandswechsels des dritten Taktsignals bei einem Drittel der Periodendauer nach dem Zeitpunkt des Zustandswechsels des zweiten Taktsignals.

Das Verfahren kann teilweise oder vollständig in Software implementiert sein, die eingerichtet ist innerhalb eines Mikrocontrollers ausgeführt zu werden und die bei ihrer Ausführung ein entsprechendes Verfahren durchführt. Der Mikrocontroller erfasst das erste und das zweite Ausgangssignal in Echtzeit. Die Software wird in Echtzeit ausgeführt.

In einer Ausführungsform sind die Schaltungsanordnung und das Verfahren ausgelegt, das wechselspannungsförmige Signal hinsichtlich des definierten Amplitudenschwellenwertes zu überwachen, wobei das wechselspannungsförmige Signal und das Referenzsignal aus unterschiedlichen Phasen abgegriffen und/oder abgeleitet sein können oder aus derselben Phase abgegriffen und/oder abgeleitet sein können.

In einer Ausführungsform sind die Schaltungsanordnung und das Verfahren ausgelegt, wechselspannungsförmige Signale, die aus unterschiedlichen Phasen abgegriffen und/oder abgeleitet sind, hinsichtlich des definierten Amplitudenschwellenwertes zu überwachen.

Sämtliche Aspekte, Maßnahmen und Merkmale einer oben erläuterten Schaltungsanordnung können in Aspekten, Maßnahmen und Merkmalen eines oben erläuterten Verfahrens ihren Niederschlag finden und umgekehrt.

Vorteilhaft finden die Schaltungsanordnung bzw. das Verfahren der oben erläuterten Art Anwendung in einem elektronischen Gerät, insbesondere in speicherprogrammierbaren Steuerungen, Logikrelais oder ähnlichen Geräten.

Weitere vorteilhafte Aspekte sind in den zugehörigen Unteransprüchen offenbart.

Die Erfindung wird nachfolgend anhand mehrerer Figuren näher beschrieben.

Es zeigen:

Figuren 1A und 1B: Ausführungsformen einer Schaltungsanordnung,

Figur 2: drei Phasen einer AC-Versorgung,

Figur 3: eine Verarbeitung eines aus einer ersten Phase abgeleiteten Eingangssignals,

Figur 4: eine Verarbeitung eines aus einer zweiten Phase abgeleiteten Eingangssignals,

Figur 5: eine Verarbeitung eines aus einer dritten Phase abgeleiteten Eingangssignals und

Figur 6: ein schematisiertes Ablaufdiagramm einer softwaregesteuerten Verarbeitung von Eingangssignalen.

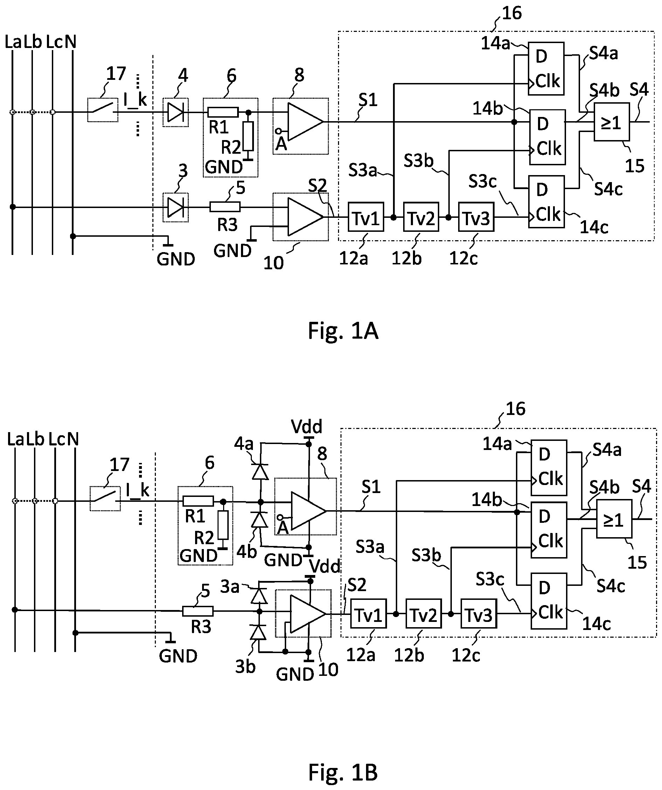

In Fig. 1A wird prinzipiell eine Schaltungsanordnung dargestellt, die eine Verarbeitung eines aus einer beliebigen Phase eines Versorgungsnetzes stammenden AC-Eingangssignals ermöglicht. Es wird ein zweites Ausgangssignal bzw. Nulldurchgangssignal S2 aus der Versorgungsspannung des Gerätes durch einen Nulldurchgangsdetektor 10 erzeugt. Aus welcher Phase das geschieht spielt grundsätzlich keine Rolle. Die drei Phasen sind in der Fig. 1A als La, Lb und Lc bezeichnet, wobei dies eine beliebige Reihenfolge L1, L2, L3 oder L2, L3, L1 oder L3, L1, L2 sein kann. N ist der Neutralleiter. Der Nulldurchgangsdetektor 10 ist in Fig. 1A in Form eines Komparators aufgebaut, der die Versorgungsspannung mit einem Massepotential GND (Null-Referenz) oder einem annähernden Massepotential vergleicht. Auf diese Weise können Nulldurchgänge der Versorgungsspannung detektiert werden. Beispielhaft ist der Nulldurchgangsdetektor 10 gemäß Fig. 1A mit der Phase La verschaltet. Die Versorgungsspannung an der Phase La wird zunächst gleichgerichtet, bevor sie in den Nulldurchgangsdetektor 10 eingespeist wird. Dies ist in Fig. 1A schematisiert in Form einer Diode 3 veranschaulicht. Zwischen der Diode 3 und dem Nulldurchgangsdetektor 10 kann ein Widerstand 5 angeordnet sein. Die Diode 3 führt beispielsweise eine Halbwellengleichrichtung durch, sodass aus dem daraus gewonnenen Signal durch den Nulldurchgangsdetektor 10 das Nulldurchgangssignal S2 erzeugt werden kann. Der Nulldurchgangsdetektor 10 ist als Komparator implementiert.

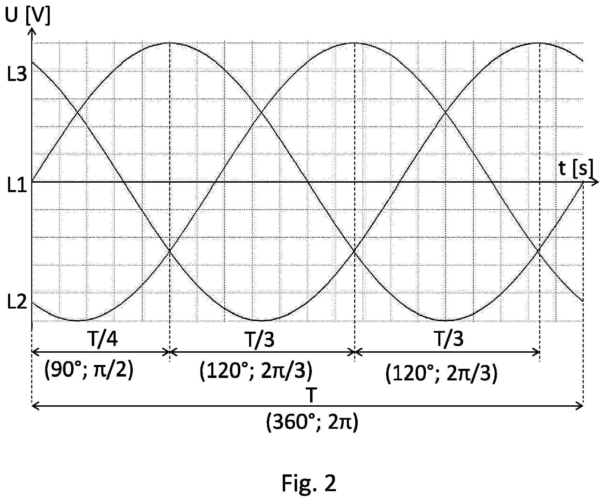

Die Bearbeitung der AC-Eingangssignale basiert auf dem Aufbau der dreiphasigen Versorgung, wie in der Fig. 2 dargestellt. In Fig. 2 sind Spannungen U als Funktion einer Zeit t dargestellt. Es handelt sich um drei sinusförmigen Spannungen, die jeweils um ein Drittel der Periodendauer T oder 120° bzw. 2π/3 phasenverschoben sind:

$$L1: u_1(t) = U_{1max} \cdot \sin(\omega t)$$

$$L2: u_2(t) = U_{2max} \cdot \sin\left(\omega t + 2\frac{\pi}{3}\right)$$

$$L3: u_3(t) = U_{3max} \cdot \sin\left(\omega t + 4\frac{\pi}{3}\right)$$

Optional weisen die Amplituden $U_{1max}$, $U_{2max}$, $U_{3max}$ den gleichen Wert auf. Grundsätzlich sollte ein AC-Eingangssignal im Scheitelpunkt, z.B. im positiven Scheitelpunkt, gemessen werden, um dessen Amplitude richtig zu ermitteln. Ausgehend von L1, wie in Fig. 2 dargestellt, erreicht L1 diesen Scheitelpunkt nach T/4 bzw. 90° oder π/2. Der positive Scheitelpunkt von L2 folgt nach einer Drittelperiode T/3 bzw. 120° oder 2π/3. Nach einer weiteren Drittelperiode T/3 bzw. 120° oder 2π/3 folgt der positive Scheitelpunkt von L3.

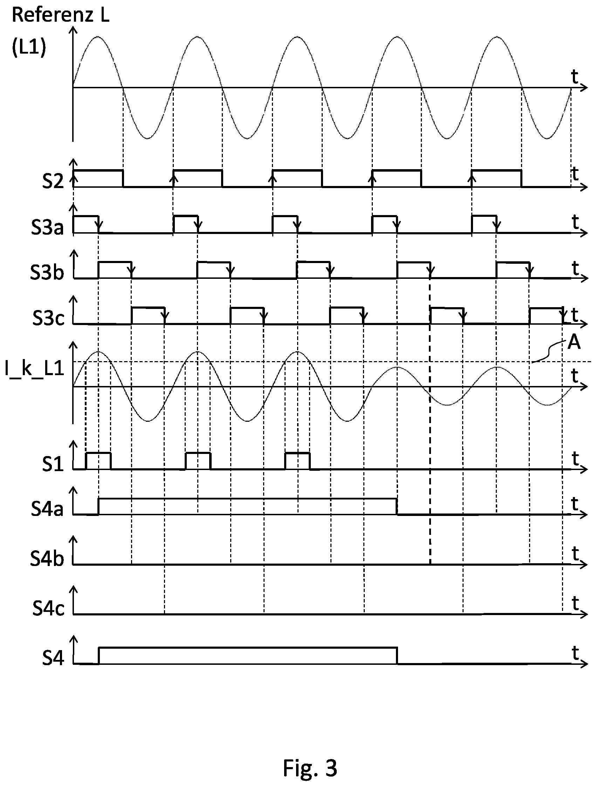

Zurück zu Fig. 1A werden die AC-Eingangssignale - repräsentativ ist ein AC-Eingangssignal I_k dargestellt - gleichgerichtet (durch einen Gleichrichter), heruntergeteilt (durch einen Tiefsetzer 6, hier in Form eines einfachen Spannungsteilers mit zwei Widerständen R1, R2) und mit einem vordefinierten Amplitudenschwellenwert A verglichen (durch einen Komparator 8) und somit als erstes Ausgangssignal S1 "digitalisiert". Das AC-Eingangssignal I_k ist ein Spannungssignal. Der Gleichrichter weist eine Diode 4 auf, die diskret realisiert sein kann. Eine in Fig. 1A nicht gezeigte Referenzspannungsquelle gibt den Amplitudenschwellenwert A ab. Der Amplitudenschwellenwert A kann z.B. konstant sein. Das erste Ausgangssignal S1 wird an den Dateneingängen D dreier Flip-Flops 14a, 14b, 14c eingespeist. Die Takteingänge Clk werden von unterschiedlichen Signalen gesteuert. Diese werden wie folgt erzeugt (vergleiche Fig. 1A mit den Fig. 3 bis 5).

Ausgehend vom Nulldurchgangssignal S2 erzeugt das erste Zeitglied Tv1, 12a das erste Taktsignal S3a als Takt für das Flip-Flop 14a. Das erste Taktsignal S3a weist einen definierten Zustandswechsel (fallende Taktflanke) auf, der nach einer Verzögerung von T/4 (90° oder π/2) auftritt. Das entspricht dem positiven Scheitelpunkt der "Versorgungsphase", hier La (z.B. L1). Das erste Taktsignal S3a triggert das zweite Zeitglied Tv2, 12b. Dieses erzeugt das zweite Taktsignal S3b als Takt für das Flip-Flop 14b. Das zweite Taktsignal S3b weist einen definierten Zustandswechsel (fallende Taktflanke) auf, der nach einer weiteren Verzögerung von T/3 (120° oder 2π/3) auftritt. Das entspricht dem positiven Scheitelpunkt der nachfolgenden Phase, hier Lb (z.B. L2). Das zweite Taktsignal S3b triggert das dritte Zeitglied Tv3, 12c. Dieses erzeugt das dritte Taktsignal S3c als Takt für das Flip-Flop 14c. Das dritte Taktsignal S3c weist einen definierten Zustandswechsel (fallende Taktflanke) auf, der nach einer weiteren Verzögerung von T/3 (120° oder 2π/3) auftritt. Das entspricht dem positiven Scheitelpunkt der nächsten, dritten Phase, hier Lc (z.B. L3).

Auf diese Weise werden die flankengesteuerten Flip-Flops 14a, 14b, 14c, durch die entsprechenden Taktsignale S3a, S3b und S3c an ihren Takteingängen Clk angesteuert, wobei zum jeweiligen Zeitpunkt eines entsprechenden Zustandswechsels (fallende Taktflanke) der Wert des ersten Ausgangssignal S1 an den Dateneingängen D der Flip-Flops 14a, 14b, 14c übernommen wird und somit die drei Zustandssignale S4a, S4b und S4c an den jeweiligen Ausgängen der Flip-Flops 14a, 14b, 14c erzeugt werden. Alternativ kann bei geeigneter Auslegung der Taktsignale S3a, S3b, S3c und der Flip-Flops 14a, 14b, 14c anstelle einer fallenden Taktflanke auch eine steigende Taktflanke verwendet werden. Schließlich werden die Zustandssignale S4a, S4b und S4c an den Ausgängen der Flip-Flops 14a, 14b, 14c einem ODER-Baustein 15 mit drei Eingängen oder einer Einheit, die in Hardware oder Software eine ODER-Funktion realisiert, zugeführt, an dessen Ausgang das endgültige Digital-Eingangssignal S4 als Gesamtzustandssignal erzeugt wird. Dieses Gesamtzustandssignal S4 kann z.B. einer weiteren logischen Verarbeitung innerhalb eines elektronischen Gerätes, in dem die Schaltungsanordnung eingesetzt wird, zugeführt werden. Ein derartiges elektronisches Gerät ist z.B. eine speicherprogrammierbare Steuerung, ein Logikrelais oder ein ähnliches Gerät.

Ist das AC-Eingangssignal I_k gleich Null (Schalter 17 geöffnet), so ist das erste Ausgangssignal S1 des Komparators 8 immer "0" und in allen drei Flip-Flops 14a, 14b, 14c wird zu jedem Zeitpunkt der Wert "0" gespeichert. Somit ist auch am Ausgang des ODER-Gatters 15 S4 = "0". Liegt dagegen ein gültiges Signal an, das die Vergleichsschwelle (Amplitudenschwellenwert A) des Komparators 8 überschreitet, so wird am ersten Ausgangssignal S1 ein Impuls erzeugt, der zentriert um den Scheitelpunkt der verwendeten Phase La, Lb oder Lc ist, und dessen Breite von der tatsächlichen Amplitude des AC-Eingangssignals I_k abhängt, d.h. je höher die Amplitude, desto breiter der Impuls des ersten Ausgangssignals S1. Da die Taktsignale S3a, S3b, S3c zeitlich den positiven Scheitelpunkten der drei Phasen entsprechen, wird der positive Impuls am ersten Ausgangssignal S1 in einem der drei Flip-Flops gespeichert, entsprechend in den Flip-Flops 14a, 14b oder 14c, wenn das AC-Eingangssignal I_k aus La, Lb, oder Lc erzeugt ist. Somit ist eines der Zustandssignale S4a, S4b oder S4c = "1", die anderen zwei bleiben "0". Durch das ODER-Gatter 15 wird dann das Gesamtzustandssignal S4 = "1", egal welcher der drei Eingänge den Wert "1" hat.

Fig. 1B zeigt eine alternative Ausführungsform der Schaltungsanordnung, die eine Weiterbildung der in Fig. 1A gezeigten Ausführungsform ist. Im Unterschied zu Fig. 1A wird in Fig. 1B das AC-Eingangssignal I_k zuerst dem Tiefsetzer 6 zugeführt. Das Ausgangssignal des Tiefsetzers 6 wird durch eine erste und eine zweite Diode 4a, 4b gleichgerichtet. Die erste Diode 4a verbindet den Eingang des Komparators 8 mit einem Versorgungsspannungsanschluss. Am Versorgungsspannungsanschluss liegt eine Versorgungsspannung Vdd an. Die erste Diode 4a ist derart gepolt, dass eine Spannung am Eingang des Komparators 8 kleiner als die Versorgungsspannung Vdd (zuzüglich einer Schwellenspannung der ersten Diode 4a) ist. Die zweite Diode 4b verbindet den Eingang des Komparators 8 mit einem Massepotentialanschluss, an dem das Massepotential GND anliegt. Die zweite Diode 4b ist derart gepolt, dass die Spannung am Eingang des Komparators 8 größer als das Massepotential GND (abzüglich einer Schwellenspannung der zweiten Diode 4b) ist.

Der Komparator 8 kann als bipolarer Komparator realisiert sein. Der Komparator 8 erzeugt das erste Ausgangssignal S1 in Abhängigkeit von einem Vergleich der Spannung am Eingang des Komparators 8 und des Amplitudenschwellenwerts A. Das erste Ausgangssignal S1 ist impulsförmig. Der Impuls des ersten Ausgangssignals S1 wird vom Mikrocontroller 16 zeitlich erfasst.

Alternativ kann der Komparator 8 als Inverter implementiert werden. Die Dioden 4a, 4b können z.B. im Inverter integriert sein. Die Dioden 4a, 4b können als Schutzdioden realisiert sein. Der Inverter weist einen "eingebauten" Amplitudenschwellenwert A auf. Die erste und die zweite Diode 4a, 4b können optional zusammen mit dem Inverter auf einem Halbleiterkörper integriert sein (z.B. ein CMOS-Inverter vom Typ HC04; CMOS ist die Abkürzung für komplementäre Metall-Oxid-Halbleiter, englisch complementary metal-oxide-semiconductor).

Zur Erzeugung des zweiten Ausgangssignals S2 wird die Spannung einer Phase zuerst dem Widerstand 5 zugeführt und dann durch eine erste und eine zweite Diode 3a, 3b gleichgerichtet. Die erste Diode 3a verbindet den Eingang des Nulldurchgangsdetektors 10 mit dem Versorgungsspannungsanschluss. Die erste Diode 3a ist derart gepolt, dass eine Spannung am Eingang des Nulldurchgangsdetektors 10 kleiner als die Versorgungsspannung Vdd (zuzüglich einer Schwellenspannung der ersten Diode 3a) ist. Die zweite Diode 3b verbindet den Eingang des Nulldurchgangsdetektors 10 mit dem Massepotentialanschluss. Die zweite Diode 3b ist derart gepolt, dass die Spannung am Eingang des Nulldurchgangsdetektors 10 größer als das Massepotential GND (abzüglich einer Schwellenspannung der zweiten Diode 3b) ist. Das zweite Ausgangssignal S2 ist impulsförmig.

Der Nulldurchgangsdetektors 10 kann als bipolarer Komparator realisiert sein.

Alternativ kann der Nulldurchgangsdetektors 10 als Inverter implementiert sein. Die Dioden 3a, 3b können z. B. im Inverter integriert sein. Die Dioden 3a, 3b können als Schutzdioden realisiert sein. Der Inverter weist den "eingebauten" Amplitudenschwellenwert A auf. Da die dem Nulldurchgangsdetektor 10 zugeführte Spannung nicht heruntergeteilt ist, ist der Spannungsanstieg schnell. So ist der zeitliche Versatz zwischen dem Nulldurchgang der Spannung der Phase und dem Schalten des Nulldurchgangsdetektors 10 sehr gering und kann vernachlässigt werden.

Die Schwelle des Nulldurchgangsdetektors 10 kann 0 V (also das Massepotential) oder eine von 0 V verschiedene Spannung sein, z.B. eine kleine positive Spannung (z.B. 2 V).

In alternativen, nicht gezeigten Ausführungsformen, kann der Komparator 8 und/oder der Nulldurchgangsdetektor 10 als ein CMOS-Gatter, z.B. ein CMOS-Gatter vom Typ HC, oder als ein Transistor realisiert werden. Bei dem Transistor kann der Amplitudenschwellenwert A z.B. diejenige Basis-Emitter Spannung sein, ab der ein Strom durch den Transistor fließt (z.B. Ube = ca. 0,65 V). Die Widerstandwerte der Widerstände R1, R2 des Tiefsetzers 6 sind dann entsprechend dimensioniert. Es können dann ausschließlich die zweiten Dioden 4b bzw. 3b vorgesehen sein. Die ersten Dioden 4a bzw. 3a können weggelassen werden.

Der Komparator 8 kann als ein Baustein, dem die Dioden 4a, 4b als Schutzdioden extern vorgeschaltet sind, oder als ein Baustein mit integrierten Dioden 4a, 4b (wie z.B. ein CMOS-Inverter mit Schutzdioden etwa HC04) hergestellt sein.

Der Nulldurchgangsdetektor 10 kann als ein Baustein, dem die Dioden 3a, 3b als Schutzdioden extern vorgeschaltet sind, oder als ein Baustein mit integrierten Dioden 3a, 3b (wie z.B. ein CMOS-Inverter mit Schutzdioden etwa HC04) hergestellt sein. Die Schutzdioden können Schutzdioden gegen elektrostatische Aufladung, abgekürzt ESD-Schutzdioden, sein.

Die Vorverarbeitung (Gleichrichten, Tiefsetzen) ist in Figuren 1A und 1B ausschließlich beispielhaft dargestellt und kann auch mit alternativen Schaltungen realisiert sein. Das Gleichrichten kann gegebenenfalls entfallen. Die Vorverarbeitung ist ausgelegt, den Komparator 8 und/oder den Nulldurchgangsdetektor 10 gegen Überspannungen (Eingang > positive Versorgung + Toleranz) und Unterspannungen (Eingang < negative Versorgung, ggf. Massepotential GND - Toleranz) zu schützen. Diese Funktion kann optional auch eine Gleichrichterdiode 3b, 4b für (negative) Unterspannungen übernehmen, ggf. kann ein zusätzlicher Schutz gegen Überspannung vorgesehen sein.

In der Fig. 3 wird beispielhaft der zeitliche Verlauf sämtlicher Signale veranschaulicht, wenn die Referenzphase L1 ist und das AC-Eingangssignal I_k auch aus L1 abgeleitet wird (I_k_L1). Der Eingang I_k_L1 wird für drei Perioden vermittels des Signals S1 als "1" (die Amplitude überschreitet den Amplitudenschwellenwert A) und für weitere zwei Perioden als "0" (die Amplitude ist kleiner als der Amplitudenschwellenwert A) dargestellt. In diesem Fall wird das Signal S4a aus dem Signal S1 - gesteuert durch die fallende Taktflanke des Taktsignals S3a - entsprechend als "1" oder "0" übernommen, S4b und S4c bleiben "0". Am Ausgang entspricht S4 dem Signal S4a und gibt mit der entsprechenden Verzögerung (T/4) den Zustand des Eingangs I_k_L1 wieder.

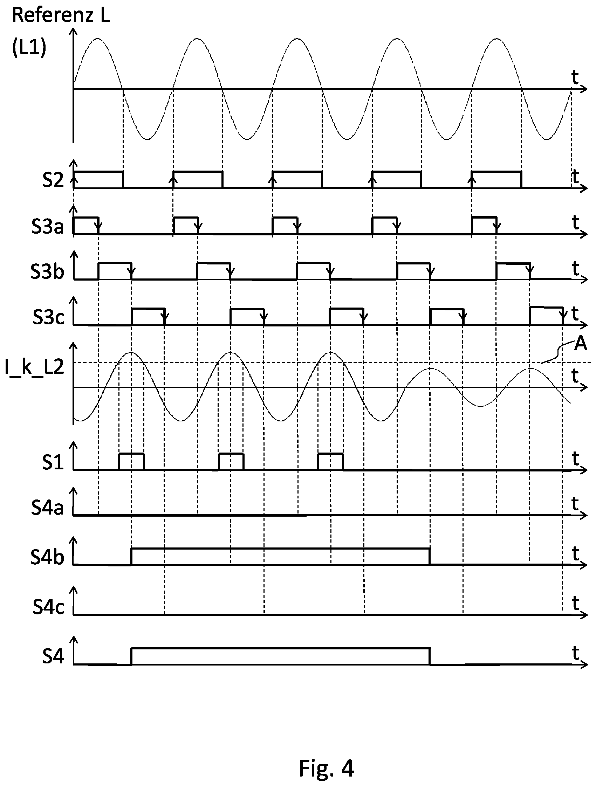

In Fig. 4 wird der zeitliche Verlauf sämtlicher Signale für den Fall veranschaulicht, dass das AC-Eingangssignal I_k aus L2 abgeleitet wird (I_k_L2). Der Eingang I_k_L2 wird für drei Perioden vermittels des Signals S1 als "1" (die Amplitude überschreitet den Amplitudenschwellenwert A) und für weitere zwei Perioden als "0" (die Amplitude ist kleiner als der Amplitudenschwellenwert A) dargestellt. In diesem Fall wird das Signal S4b aus dem Signal S1 - gesteuert durch die fallende Taktflanke des Taktsignals S3b - entsprechend als "1" oder "0" übernommen, S4a und S4c bleiben "0". Am Ausgang entspricht S4 dem Signal S4b und gibt mit der entsprechenden Verzögerung (T/4 + T/3 = 7T/12) den Zustand des Eingangs I_k_L2 wieder.

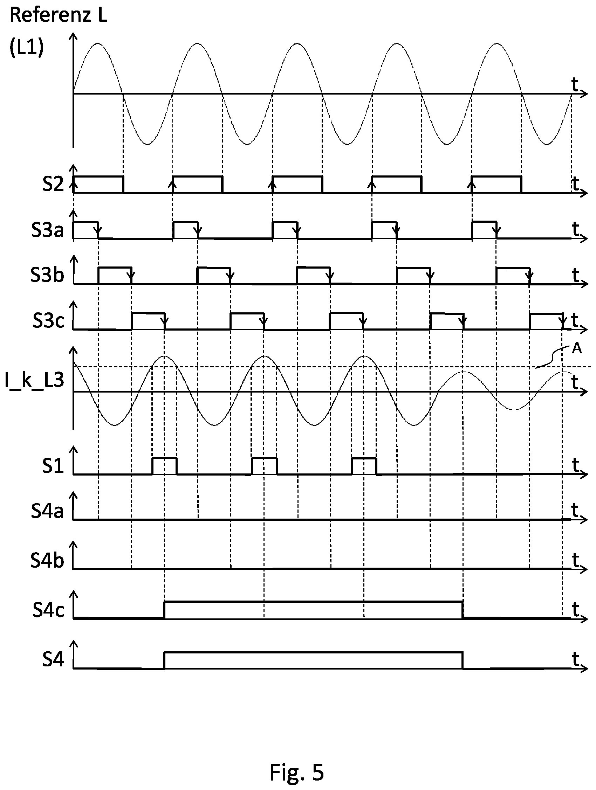

In Fig. 5 wird der zeitliche Verlauf sämtlicher Signale für den Fall veranschaulicht, dass das AC-Eingangssignal I_k aus L3 abgeleitet wird (I_k_L3). Der Eingang I_k_L3 wird für drei Perioden vermittels des Signals S1 als "1" (die Amplitude überschreitet den Amplitudenschwellenwert A) und für weitere zwei Perioden als "0" (die Amplitude ist kleiner als der Amplitudenschwellenwert A) dargestellt. In diesem Fall wird das Signal S4c aus dem Signal S1 - gesteuert durch die fallende Taktflanke des Taktsignals S3c - entsprechend als "1" oder "0" übernommen, S4a und S4b bleiben "0". Am Ausgang entspricht S4 dem Signal S4c und gibt mit der entsprechenden Verzögerung (T/4 + 2T/3 = 11T/12) den Zustand des Eingangs I_k_L3 wieder.

Man erkennt, dass die Methode die Erfassung der entsprechenden Eingangssignale I_k_L1, I_k_L2, I_k_L3 innerhalb eine Periode T ermöglicht, also z.B. bei 50Hz nach spätestens 20ms.

Vorzugsweise werden einige oder sämtliche der im rechten Kästchen in Fig. 1A und 1B markierten Elemente (Zeitglieder 12a, 12b, 12c, Flip-Flops 14a, 14b 14c, ODER-Gatter 15) in einem Mikrocontroller 16 implementiert. Die Eingangssignale S1 (eins oder mehrere) werden als normale Eingänge zugeschaltet. Das Nulldurchgangssignal S2 wird an einem Interrupt-Eingang zugeschaltet. Das ODER-Gatter 15 kann als ODER-Funktion in Software durch den Mikrocontroller 16 realisiert sein.

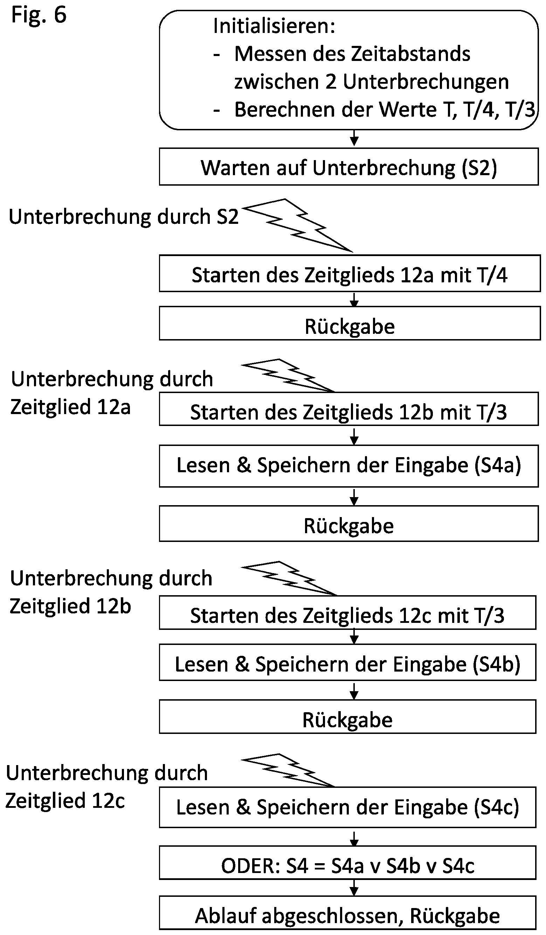

Fig. 6 zeigt prinzipiell, wie die Bearbeitung in Software erfolgen kann. Im Folgenden wird von mehreren zu überwachenden AC-Eingangssignalen I_K ausgegangen. In einer Interrupt-Routine des Mikrocontrollers 16 wird, ausgelöst durch einen Interrupt (hier als Unterbrechung bezeichnet) des zweiten Ausgangssignals S2, ein erster Timer zur Realisierung des ersten Zeitglieds 12a mit dem Wert T/4 gestartet, der am Ende (nach dessen Ablauf) einen weiteren Interrupt erzeugt. Zu diesem Zeitpunkt werden die ersten Ausgangsignale S1 gelesen und entsprechend die ersten Zustandssignale S4a im Speicher abgelegt. Gleichzeitig wird der erste Timer zur Realisierung des zweiten Zeitglieds 12b mit dem Wert T/3 erneut gestartet. Nach Ablauf der Zeit wird ein weiterer Interrupt erzeugt, die ersten Ausgangsignale S1 erneut gelesen und die zweiten Zustandssignale S4b im Speicher abgelegt. Gleichzeitig wird der erste Timer zur Realisierung des dritten Zeitglieds 12c wieder mit T/3 gestartet. Nach Ablauf der Zeit wird ein weiterer Interrupt erzeugt, schließlich die ersten Ausgangssignale S1 erneut gelesen und die dritten Zustandssignale S4c im Speicher abgelegt. Sämtliche zwischengespeicherten Werte der Zustandssignale S4a, S4b und S4c werden ODER-verknüpft. Als Ergebnis erhält man nun die digitalisierten Eingangswerte S4. Der erste Timer realisiert somit das erste, zweite und dritte Zeitglied 12a, 12b, 12c. Ein Timer kann auch Zeitgeber genannt werden. Der Interrupt kann auch als Unterbrechung bezeichnet werden.

Um die Periode T zu ermitteln, wird beim Einschalten und Initialisieren des Mikrocontrollers 16 bzw. des Gerätes das Nulldurchgangssignal S2 zeitlich gemessen. Man misst über einen Timer die Zeitabstände zwischen zwei aufeinander folgenden Impulsen. In der Regel unterscheidet man dadurch zwischen 50Hz und 60Hz, aber andere Frequenzen können auch unterstützt werden. Anschließend werden die Timer-Werte berechnet:

- Bei 50Hz: T = 20 ms, T/4 = 5 ms, T/3 = 6,666 ms
- Bei 60Hz: T = 16,666 ms, T/4 = 4,166 ms, T/3 = 5,555 ms.

Alternativ können das erste, zweite und dritte Zeitglied 12a, 12b, 12c durch einen ersten, einen zweiten und einen dritten Timer oder Zeitgeber realisiert werden, die verkettet gestartet werden. Die Verzögerungswerte sind ebenfalls T/4, T/3 und T/3.

In einer alternativen, nicht in Fig. 6 dargestellten Ausführungsform können das erste, zweite und dritte Zeitglied 12a, 12b, 12c durch einen ersten, einen zweiten und einen dritten Timer oder Zeitgeber realisiert werden, die parallel nach der Unterbrechung durch das zweite Ausgangssignal S2 gestartet werden. Der Verzögerungswert des ersten Timers ist dann T/4, des zweiten Timers T • 7 / 12 und des dritten Timers T • 11/12.

Die dargestellten Ausführungsformen sind lediglich beispielhaft. In alternativen, nicht-dargestellten Ausführungsformen, die in den Figuren 1A und 1B mittels Punkten angedeutet sind, kann mindestens ein weiteres AC-Eingangssignal I_k' der Schaltungsanordnung zugeführt werden. Das weitere AC-Eingangssignal I_k' kann auch an einer der Phasen La, Lb oder LC abgegriffen werden. Daher kann die Schaltungsanordnung mindestens einen weiteren Komparator und nachgeschaltete drei weitere Flip-Flops umfassen. Die Signale des Nulldurchgangsdetektors 10 und der Zeitglieder 12a, 12b, 12c sind geeignet zu überwachen, ob die Amplitude des weiteren AC-Eingangssignals I_k' über dem Amplitudenschwellwert A ist. Eine Anzahl von n AC-Eingangssignalen, die beliebig an einer der drei unterschiedlichen Phasen L1, L2 oder L3 abgegriffen werden können, wird der Schaltungsanordnung zugeleitet und erfasst. Dabei kann n gleich 1 oder 2 oder größer als 2 sein.

Bezugszeichenliste:

| | |
|---|---|
| 3, 3a, 3b | Diode |
| 4, 4a, 4b | Diode |
| 5 | Widerstand |
| 6 | Tiefsetzer |
| 8 | Komparator |
| 10 | Nulldurchgangsdetektor |
| 12a, 12b, 12c | Zeitglied |
| 14a, 14b, 14c | Flip-Flop |
| 15 | ODER-Gatter |
| 16 | Mikrocontroller |
| 17 | Schalter |
| A | Amplitudenschwellenwert |
| D | Dateneingang eines Flip-Flops |
| Clk | Takteingang eines Flip-Flops |
| I_k, I_k_L1 | AC-Eingangssignal |
| I_k_L2, I_k_L3 | AC-Eingangssignal |
| GND | Massepotential |
| La, Lb, Lc | Phasen |
| L1, L2, L3 | Phasen |
| N | Neutralleiter |
| S1 | erstes Ausgangssignal |
| S2 | zweites Ausgangssignal |
| S3a, S3b, S3c | Taktsignale |
| S4a, S4b, S4c | Zustandssignale |
| S4 | Gesamtzustandssignal |
| U | Spannung |
| Vdd | Versorgungsspannung |
| T | Periodendauer |
| t | Zeit |

**Patentansprüche**

1. Schaltungsanordnung zur Überwachung wechselspannungsförmiger Signale (I_k) mit:

    - einem oder mehreren Komparatoren (8), denen jeweils an einem ersten Vergleichseingang ein zu überwachendes, wechselspannungsförmiges Signal (I_k) oder ein daraus gewonnenes Signal zuführbar ist zum Vergleich mit einem an einem zweiten Vergleichseingang anliegenden, definierten Amplitudenschwellenwert (A), sodass an einem Ausgang ein erstes Ausgangssignal (S1) erzeugbar ist,
    - einem Nulldurchgangsdetektor (10), dem an einem Überwachungseingang ein Referenzsignal oder ein daraus gewonnenes Signal zuführbar ist, sodass an einem Ausgang des Nulldurchgangsdetektors (10) ein zweites Ausgangssignal (S2) erzeugbar ist,
    - einem dem Nulldurchgangsdetektor (10) nachgeschalteten ersten Zeitglied (12a) zur Erzeugung eines ersten Taktsignals (S3a) in Abhängigkeit vom zweiten Ausgangssignal (S2),
    - einem dem Nulldurchgangsdetektor (10) nachgeschalteten zweiten Zeitglied (12b) zur Erzeugung eines zweiten Taktsignals (S3b) in Abhängigkeit vom zweiten Ausgangssignal (S2) oder in Abhängigkeit vom ersten Taktsignal (S3a), wobei sich das zweite Taktsignal (S3b) vom ersten Taktsignal (S3a) unterscheidet,
    - einem ersten flankengesteuerten Flip-Flop (14a) und

- einem zweiten flankengesteuerten Flip-Flop (14b),

wobei der Ausgang des Komparators (8) oder die Ausgänge der Komparatoren (8) jeweils mit einem zustandsgesteuerten Eingang (D) des ersten Flip-Flops (14a) bzw. des zweiten Flip-Flops (14b) verbunden sind und

wobei ein Ausgang des ersten Zeitglieds (12a) mit einem flankengesteuerten Eingang des ersten Flip-Flops (14a) verbunden ist und ein Ausgang des zweiten Zeitglieds (12b) mit einem flankengesteuerten Eingang des zweiten Flip-Flops (14b) verbunden ist derart, dass ein erstes Zustandssignal (S4a) an einem Ausgang des ersten Flip-Flops (14a) erzeugbar ist und ein zweites Zustandssignal (S4b) an einem Ausgang des zweiten Flip-Flops (14b) erzeugbar ist.

2. Schaltungsanordnung nach Anspruch 1, wobei das zweite Zeitglied (12b) dem ersten Zeitglied (12a) nachgeschaltet ist und eingerichtet ist, durch das erste Taktsignal (S3a) zur Erzeugung des zweiten Taktsignals (S3b) getriggert zu werden.

3. Schaltungsanordnung nach Anspruch 1 oder 2, wobei die Flip-Flops (14a, 14b) und/oder die Zeitglieder (12a, 12b) durch Software innerhalb eines Mikrocontrollers (16) realisiert sind.

4. Schaltungsanordnung nach einem der Ansprüche 1 bis 3, weiter aufweisend ein ODER-Gatter zur Erzeugung eines Gesamtzustandssignals (S4) aus dem ersten Zustandssignal (S4a) und dem zweiten Zustandssignal (S4b).

5. Verfahren zur Überwachung wechselspannungsförmiger Signale (I_k) mit folgenden Verfahrensschritten:

a) Erfassen eines zu überwachenden, wechselspannungsförmigen Signals (I_k_L1, I_k_L2),
b) Prüfen, ob ein Amplitudenwert des erfassten wechselspannungsförmigen Signals (I_k_L1, I_k_L2) oder eines daraus gewonnenen Signals über oder unter einem definierten Amplitudenschwellenwert (A) liegt, und in Abhängigkeit davon Erzeugen eines ersten Ausgangssignals (S1),
c) Überwachen der Nulldurchgänge eines wechselspannungsförmigen Referenzsignals oder eines daraus gewonnenen Signals und in Abhängigkeit davon Erzeugen eines zweiten Ausgangssignals (S2),
d1) Erzeugen eines ersten Taktsignals (S3a) in Abhängigkeit vom zweiten Ausgangssignal (S2) und
d2) Erzeugen eines zweiten Taktsignals (S3b) in Abhängigkeit vom zweiten Ausgangssignal (S2) oder in Abhängigkeit vom ersten Taktsignal (S3a),
wobei sich das erste Taktsignal (S3a) vom zweiten Taktsignal (S3b) zumindest durch den Zeitpunkt eines definierten Zustandswechsels unterscheidet, und
f) Erzeugen eines ersten Zustandssignals (S4a) bzw. eines zweiten Zustandssignals (S4b) durch Auswerten des ersten Ausgangssignals (S1) im Zeitpunkt des Zustandswechsels des ersten Taktsignals (S3a) bzw. im Zeitpunkt des Zustandswechsels des zweiten Taktsignals (S3b).

6. Verfahren nach Anspruch 5, wobei das erste Taktsignal (S3a) durch ein erstes Zeitglied (12a) erzeugt wird, das durch das zweite Ausgangssignal (S2) zur Erzeugung des ersten Taktsignals (S3a) getriggert wird, und wobei das zweite Taktsignal (S3b) durch ein zweites Zeitglied (12b) erzeugt wird, das durch das erste Taktsignal (S3a) zur Erzeugung des zweiten Taktsignals (S3b) getriggert wird.

7. Verfahren nach Anspruch 6, wobei das erste Zeitglied (12a) und das zweite Zeitglied (12b) softwaregesteuert innerhalb eines Mikrocontrollers (16) realisiert sind und die folgenden Verfahrensschritte durchgeführt werden:

- Erzeugen eines ersten Interrupts im Mikrocontroller (16) durch das zweite Ausgangssignal (S2),
- Starten eines ersten Timers des Mikrocontrollers (16) zur Realisierung des ersten Zeitglieds (12a) bei Auftreten des ersten Interrupts,
- Erzeugen eines zweiten Interrupts im Mikrocontroller (16) bei Ablauf des ersten Timers,
- Starten des ersten Timers oder eines zweiten Timers des Mikrocontrollers (16) zur Realisierung des zweiten Zeitglieds (12b) bei Auftreten des zweiten Interrupts,
- Lesen und Speichern des bei Auftreten des zweiten Interrupts vorliegenden Wertes des ersten Ausgangssignals (S1) als erstes Zustandssignal (S4a),
- Erzeugen eines dritten Interrupts im Mikrocontroller (16) bei Ablauf des ersten oder des zweiten Timers, und
- Lesen und Speichern des bei Auftreten des dritten Interrupts vorliegenden Wertes des ersten Ausgangssignals (S1) als zweites Zustandssignal (S4b).

8. Verfahren nach einem der Ansprüche 5 bis 7, wobei der Zeitpunkt des Zustandswechsels des ersten Taktsignals (S3a) mit dem Zeitpunkt eines Scheitelpunktes eines ersten, definierten wechselspannungsförmigen Signals (I_k_L1) korreliert und der Zeitpunkt des Zustandswechsels des zweiten Taktsignals (S3b) mit dem Zeitpunkt eines Scheitelpunktes eines zweiten, definierten wechselspannungsförmigen Signals (I_k_L2) korreliert, das zum ersten wechselspannungsförmigen Signal (I_k_L1) phasenverschoben ist.

9. Verfahren nach Anspruch 8, wobei das wechselspannungsförmige Referenzsignal und das erste, definierte wechselspannungsförmige Signal (I_k_L1) frequenz- und phasengleich sind und der Zeitpunkt des Zustandswechsels des ersten Taktsignals (S3a) bei einem Viertel der Periodendauer (T) nach einem Nulldurchgang des Referenzsignals liegt und der Zeitpunkt des Zustandswechsels des zweiten Taktsignals (S3b) bei einem Drittel der Periodendauer (T) nach dem Zeitpunkt des Zustandswechsels des ersten Taktsignals (S3a) liegt.

10. Verfahren nach einem der Ansprüche 5 bis 9, umfassend:

   - Erzeugen eines dritten Taktsignals (S3c) in Abhängigkeit vom zweiten Ausgangssignal (S2) oder in Abhängigkeit vom zweiten Taktsignal (S3b),
   wobei sich das dritte Taktsignal (S3c) vom ersten und vom zweiten Taktsignal (S3a, S3b) zumindest durch den Zeitpunkt eines definierten Zustandswechsels unterscheidet, und
   - Erzeugen eines dritten Zustandssignals (S4c) durch Auswerten des ersten Ausgangssignals (S1) im Zeitpunkt des Zustandswechsels des dritten Taktsignals (S3c).

11. Software-Produkt, das eingerichtet ist, innerhalb eines Mikrocontrollers (16) ausgeführt zu werden, und das bei dessen Ausführung ein Verfahren nach einem der Ansprüche 5 bis 10 durchführt.

**Claims**

1. Circuit arrangement for monitoring alternating voltage signals (I_k), comprising:

   - one or more comparators (8), which can each be supplied at a first comparison input with an alternating voltage signal (I_k) to be monitored or a signal obtained therefrom for comparison with a defined amplitude threshold value (A) applied to a second comparison input, such that a first output signal (S1) can be generated at an output,
   - a zero crossing detector (10) which can be supplied at a monitoring input with a reference signal or a signal obtained therefrom such that a second output signal (S2) can be generated at an output of the zero crossing detector (10),
   - a first timer (12a) connected downstream of the zero crossing detector (10) for generating a first clock signal (S3a) on the basis of the second output signal (S2),
   - a second timer (12b) connected downstream of the zero crossing detector (10) for generating a second clock signal (S3b) on the basis of the second output signal (S2) or on the basis of the first clock signal (S3a),
   wherein the second clock signal (S3b) is different from the first clock signal (S3a),
   - a first edge-triggered flip-flop (14a), and
   - a second edge-triggered flip-flop (14b),

   wherein the output of the comparator (8) or the outputs of the comparators (8) are each connected to a state-controlled input (D) of the first flip-flop (14a) or the second flip-flop (14b), and
   wherein an output of the first timer (12a) is connected to an edge-triggered input of the first flip-flop (14a) and an output of the second timer (12b) is connected to an edge-triggered input of the second flip-flop (14b) such that a first state signal (S4a) can be generated at an output of the first flip-flop (14a) and a second state signal (S4b) can be generated at an output of the second flip-flop (14b).

2. Circuit arrangement according to claim 1, wherein the second timer (12b) is connected downstream of the first timer (12a) and is configured to be triggered by the first clock signal (S3a) in order to generate the second clock signal (S3b).

3. Circuit arrangement according to either claim 1 or claim 2, wherein the flip-flops (14a, 14b) and/or the timers (12a, 12b) are implemented by software within a microcontroller (16).

4. Circuit arrangement according to any of claims 1 to 3, further comprising an OR gate for generating a total state signal (S4) from the first state signal (S4a) and the second state signal (S4b).

5. Method for monitoring alternating voltage signals (I_k) having the following method steps:

    a) detecting an alternating voltage signal to be monitored (I_k_L1, I_k_L2),
    b) checking whether an amplitude value of the detected alternating voltage signal (I_k_L1, I_k_L2) or a signal obtained therefrom is above or below a defined amplitude threshold value (A), and, on the basis thereof, generating a first output signal (S1),
    c) monitoring the zero crossings of an alternating voltage reference signal or a signal obtained therefrom and, on the basis thereof, generating a second output signal (S2),
    d1) generating a first clock signal (S3a) on the basis of the second output signal (S2) and
    d2) generating a second clock signal (S3b) on the basis of the second output signal (S2) or on the basis of the first clock signal (S3a),
    wherein the first clock signal (S3a) is different from the second clock signal (S3b) at least by the time of a defined state change, and
    f) generating a first state signal (S4a) or a second state signal (S4b) by evaluating the first output signal (S1) at the time of the state change of the first clock signal (S3a) or at the time of the state change of the second clock signal (S3b).

6. Method according to claim 5, wherein the first clock signal (S3a) is generated by a first timer (12a) triggered by the second output signal (S2) in order to generate the first clock signal (S3a), and
   wherein the second clock signal (S3b) is generated by a second timer (12b) triggered by the first clock signal (S3a) in order to generate the second clock signal (S3b).

7. Method according to claim 6, wherein the first timer (12a) and the second timer (12b) are implemented in a software-controlled manner within a microcontroller (16) and the following method steps are performed:

    - generating a first interrupt in the microcontroller (16) via the second output signal (S2),
    - starting a first timer of the microcontroller (16) in order to implement the timer (12a) when the first interrupt occurs,
    - generating a second interrupt in the microcontroller (16) when the first timer expires,
    - starting the first timer or a second timer of the microcontroller (16) in order to implement the second timer (12b) when the second interrupt occurs,
    - reading and storing the value of the first output signal (S1) as a first state signal (S4a), which value is present when the first interrupt occurs,
    - generating a third interrupt in the microcontroller (16) when the first or the second timer expires, and
    - reading and storing the value of the first output signal (S1) as a second state signal (S4b), which value is present when the third interrupt occurs.

8. Method according to any of claims 5 to 7, wherein the time of the state change of the first clock signal (S3a) correlates with the time of an apex of a first, defined alternating voltage signal (I_k_L1) and the time of the state change of the second clock signal (S3b) correlates with the time of an apex of a second, defined alternating voltage signal (I_k_L2) which is phase-shifted to the first alternating voltage signal (I_k_L1).

9. Method according to claim 8, wherein the alternating voltage reference signal and the first, defined alternating voltage signal (I_k_L1) have the same frequency and phase and the time of the state change of the first clock signal (S3a) is at a quarter of the period duration (T) after a zero crossing of the reference signal and the time of the state change of the second clock signal (S3b) is at a third of the period duration (T) after the time of the state change of the first clock signal (S3a).

10. Method according to any of claims 5 to 9, comprising:

    - generating a third clock signal (S3c) on the basis of the second output signal (S2) or on the basis of the second clock signal (S3b),
    wherein the third clock signal (S3c) differs from the first and the second clock signal (S3a, S3b) at least by the time of a defined state change, and
    - generating a third state signal (S4c) by evaluating the first output signal (S1) at the time of the state change of the third clock signal (S3c).

11. Software product configured to be executed within a microcontroller (16) and which performs a method according to any of claims 5 to 10 when executed.

**Revendications**

1.  Système de circuit permettant de surveiller des signaux (I_k) sous forme de tension alternative, comportant :

    - un ou plusieurs comparateurs (8), auxquels respectivement peut être amené, au niveau d'une première entrée de comparaison, un signal (I_k) sous forme de tension alternative à surveiller ou un signal obtenu à partir de celui-ci pour le comparer à une valeur seuil d'amplitude (A) définie se trouvant au niveau d'une seconde entrée de comparaison, de sorte qu'un premier signal de sortie (S1) puisse être produit au niveau d'une sortie,
    - un détecteur de passage par zéro (10), auquel peut être amené, au niveau d'une entrée de surveillance, un signal de référence ou un signal obtenu à partir de celui-ci, de sorte qu'un second signal de sortie (S2) puisse être produit au niveau d'une sortie du détecteur de passage par zéro (10),
    - un premier temporisateur (12a) monté en aval du détecteur de passage par zéro (10) pour générer un premier signal d'horloge (S3a) en fonction du second signal de sortie (S2),
    - un second temporisateur (12b) monté en aval du détecteur de passage par zéro (10) pour générer un deuxième signal d'horloge (S3b) en fonction du second signal de sortie (S2) ou en fonction du premier signal d'horloge (S3a),
    dans lequel le deuxième signal d'horloge (S3b) est différent du premier signal d'horloge (S3a),
    - une première bascule commandée par front (14a) et
    - une seconde bascule commandée par front (14b),

    dans lequel la sortie du comparateur (8) ou les sorties des comparateurs (8) sont respectivement connectées à une entrée commandée par l'état (D) de la première bascule (14a) ou de la seconde bascule (14b) et dans lequel une sortie du premier temporisateur (12a) est connectée à une entrée commandée par front de la première bascule (14a) et une sortie du second temporisateur (12b) est connectée à une entrée commandée par front de la seconde bascule (14b) de sortie qu'un premier signal d'état (S4a) puisse être produit au niveau d'une sortie de la première bascule (14a) et qu'un deuxième signal d'état (S4b) puisse être produit au niveau d'une sortie de la seconde bascule (14b).

2.  Système de circuit selon la revendication 1, dans lequel le second temporisateur (12b) est monté en aval du premier temporisateur (12a) et est conçu pour être déclenché par le premier signal d'horloge (S3a) pour générer le deuxième signal d'horloge (S3b).

3.  Système de circuit selon la revendication 1 ou 2, dans lequel les bascules (14a, 14b) et/ou les temporisateurs (12a, 12b) sont réalisés par logiciel au sein d'un micro-contrôleur (16).

4.  Système de circuit selon l'une quelconque des revendications 1 à 3, comportant en outre une porte OU pour générer un signal d'état global (S4) à partir du premier signal d'état (S4a) et du deuxième signal d'état (S4b).

5.  Procédé pour surveiller des signaux (I_k) sous forme de tension alternative, comportant les étapes de procédé suivantes :

    a) détection d'un signal (I_k_L1, I_k_L2) sous forme de tension alternative à surveiller,
    b) vérification pour savoir si une valeur d'amplitude du signal (I_k_L1, I_k_L2) sous forme de tension alternative détecté ou d'un signal obtenu à partir de celui-ci se trouve au-dessus ou au-dessous d'une valeur seuil d'amplitude (A) définie et, en fonction du résultat, génération d'un premier signal de sortie (S1),
    c) surveillance du passage par zéro d'un signal de référence sous forme de tension alternative ou d'un signal obtenu à partir de celui-ci et, en fonction du résultat, génération d'un second signal de sortie (S2),
    d1) génération d'un premier signal d'horloge (S3a) en fonction du second signal de sortie (S2) et
    d2) génération d'un deuxième signal d'horloge (S3b) en fonction du second signal de sortie (S2) ou en fonction du premier signal d'horloge (S3a),
    dans lequel le premier signal d'horloge (S3a) est différent du deuxième signal d'horloge (S3b) au moins par le moment d'un changement d'état défini, et
    f) génération d'un premier signal d'état (S4a) ou d'un deuxième signal d'état (S4b) par évaluation du premier signal de sortie (S1) au moment du changement d'état du premier signal d'horloge (S3a) ou au moment du changement d'état du deuxième signal d'horloge (S3b).

6.  Procédé selon la revendication 5, dans lequel le premier signal d'horloge (S3a) est généré par un premier temporisateur (12a), qui est déclenché par le second signal de sortie (S2) pour générer le premier signal d'horloge (S3a), et

dans lequel le second signal d'horloge (S3b) est généré par un second temporisateur (12b). qui est déclenché par le premier signal d'horloge (S3a) pour générer le deuxième signal d'horloge (S3b).

7. Procédé selon la revendication 6, dans lequel le premier temporisateur (12a) et le second temporisateur (12b) sont réalisé de manière commandée par logiciel au sein d'un micro-contrôleur (16) et les étapes de procédé suivantes sont exécutées :

   - génération d'une première interruption dans le micro-contrôleur (16) par le second signal de sortie (S2),
   - démarrage d'un premier minuteur du micro-contrôleur (16) pour réaliser le premier temporisateur (12a) lors de l'apparition de la première interruption,
   - génération d'une deuxième interruption dans le micro-contrôleur (16) à l'expiration du premier minuteur,
   - démarrage d'un premier minuteur ou d'un second minuteur du micro-contrôleur (16) pour réaliser le second temporisateur (12b) lors de l'apparition de la deuxième interruption,
   - lecture et mémorisation de la valeur du premier signal de sortie (S1) présente lors de l'apparition de la deuxième interruption en tant que premier signal d'état (S4a),
   - génération d'une troisième interruption dans le micro-contrôleur (16) à l'expiration du premier ou du second minuteur et
   - lecture et mémorisation de la valeur du premier signal de sortie (S1) présente lors de l'apparition de la troisième interruption en tant que deuxième signal d'état (S4b).

8. Procédé selon l'une quelconque des revendications 5 à 7, dans lequel le moment du changement d'état du premier signal d'horloge (S3a) est corrélé au moment d'un point de crête d'un premier signal (I_k_L1) sous forme de tension alternative défini et le moment du changement d'état du deuxième signal d'horloge (S3b) est corrélé au moment d'un point de crête d'un second signal (I_k_L2) sous forme de tension alternative défini, qui est déphasé par rapport au premier signal (I_k_L1) sous forme de tension alternative.

9. Procédé selon la revendication 8, dans lequel le signal de référence sous forme de tension alternative et le premier signal (I_k_L1) sous forme de tension alternative sont identiques en fréquence et en phase et le moment du changement d'état du premier signal d'horloge (S3a) se trouve à un quart de la durée de période (T) après un passage par zéro du signal de référence et le moment du changement d'état du deuxième signal d'horloge (S3b) se trouve à un tiers de la durée de période (T) après le moment du changement d'état du premier signal d'horloge (S3a).

10. Procédé selon l'une quelconque des revendications 5 à 9, comprenant :

    - la génération d'un troisième signal d'horloge (S3c) en fonction du second signal de sortie (S2) ou en fonction du deuxième signal d'horloge (S3b), dans lequel le troisième signal d'horloge (S3c) est différent du premier et du deuxième signal d'horloge (S3a, S3b) au moins par le moment d'un changement d'état défini, et
    - la génération d'un troisième signal d'état (S4c) par évaluation du premier signal de sortie (S1) au moment du changement d'état du troisième signal d'horloge (S3c).

11. Produit logiciel, qui est conçu pour être exécuté au sein d'un micro-contrôleur (16) et qui, lors de son exécution, met en oeuvre un procédé selon l'une quelconque des revendications 5 à 10.

Fig. 1A

Fig. 1B

Fig. 2

Fig. 3

Fig. 4

**Fig. 5**

Fig. 6

Initialisieren:
- Messen des Zeitabstands
  zwischen 2 Unterbrechungen
- Berechnen der Werte T, T/4, T/3

Warten auf Unterbrechung (S2)

Unterbrechung durch S2

Starten des Zeitglieds 12a mit T/4

Rückgabe

Unterbrechung durch
Zeitglied 12a

Starten des Zeitglieds 12b mit T/3

Lesen & Speichern der Eingabe (S4a)

Rückgabe

Unterbrechung durch
Zeitglied 12b

Starten des Zeitglieds 12c mit T/3

Lesen & Speichern der Eingabe (S4b)

Rückgabe

Unterbrechung durch
Zeitglied 12c

Lesen & Speichern der Eingabe (S4c)

ODER: S4 = S4a v S4b v S4c

Ablauf abgeschlossen, Rückgabe

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 0935758 B1

- GB 1254975 A